# EUROPEAN PATENT APPLICATION

(11) **EP 4 541 475 A1**
(43) Date of publication of application: **23.04.2025**
(21) Application number: 23204858.7
(22) Date of filing: 20.10.2023
(51) Int. Cl.: B21D 19/08, B21D 31/02, B23G 1/16, B23P 15/00, H10K 59/10, B32B 3/06, B21D 35/00, B21D 53/24

(54) **TAP PROCESSING METHOD FOR ACM PANEL**

(71) Applicant: Ohsung D&E Co., Ltd., Busan (KR)
(72) Inventor: CHOI, Young Dae, Gyeonggi-do, 10589 (KR); KIM, Sun Gyu, Gyeonggi-do, 10589 (KR)
(74) Representative: Mayr Kotsch Patentanwalt Rechtsanwältin Partnerschaftsgesellschaft mbB

(57) **Abstract**

A tap processing method for an aluminum composite material (ACM) panel includes an inner burring operation of burring the inner skin of the ACM panel so that an inner burr formed in the inner skin extends toward the outer skin while compressing the core layer, an outer burring operation of burring the outer skin of the ACM panel so that the outer burr formed in the outer skin extends toward the inner skin while compressing the core layer and the inner burr and the outer burr are also continuously connected to each other, and a tapping operation of forming a continuous screw thread in the inner burr and the outer burr continuously connected to each other. Burring work in the inner burring operation and the outer burring operation is performed by a scrapless burring punch (SBP).

## Description

### BACKGROUND

### 1. Field of the Invention

The present disclosure relates to a tap processing method for an aluminum composite material (ACM) panel, which is used to attach a system board to an ACM panel material back cover of a display device.

### 2. Discussion of Related Art

Organic light emitting diodes (OLEDs) each include a hole injection electrode, an organic light emitting layer, and an electron injection electrode and emit light by energy generated when excitons generated by combining electrons and holes inside the organic light emitting layer fall from an excited state to a ground state.

Based on this principle, OLEDs have self-luminous properties and do not require a separate light source unlike liquid crystal displays, and thus a thickness and weight thereof may be reduced.

Further, since OLEDs exhibit high-quality properties such as low power consumption, high luminance, and a high response speed, an OLED is considered to be a next-generation display device for a portable electronic device.

In general, OLEDs include an OLED panel including organic light emitting layers therein and a back cover coupled to the OLED panel to support the OLED panel, and a system board is provided on a rear surface of the back cover.

Meanwhile, when an OLED is operating, high-temperature operating heat generated from the system board provided on the rear surface of the back cover is transferred to the OLED panel, and thus the organic light emitting layer of the OLED panel is degraded. In this case, the degraded organic light emitting layer is denatured and decomposed, thereby causing degradation of image quality such as afterimages due to differences in luminance between pixels and degradation of lifetime.

Thus, the back cover needs to be made of a material having high rigidity and high thermal conductivity to stably support the OLED panel, and at the same time, facilitate discharge of the operating heat. In order to satisfy this condition, in recent years, an ACM panel is used as a material of the back cover.

The ACM panel includes a metallic inner skin, a metallic outer skin, and a resin core layer between both skins, has significant structural strength and heat dissipation performance as compared to a thickness thereof, and thus is suitable as the material of the back cover.

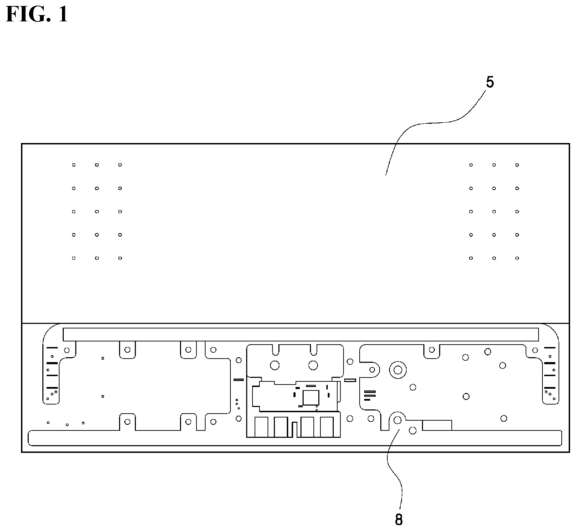

Meanwhile, as illustrated in FIG. 1, a system board 5 is mounted on a forming part of a back cover 8 and fastened to the back cover 8 using a screw coupling method. In this case, since the ACM panel constituting the back cover 8 is very thin, a tap cannot be processed to have a depth enough to maintain strong screw fastening strength.

In the related art, in order to solve this problem, the screw is fastened by adding a reinforcement plate to a screw fastening portion of the back cover 8 and forming a tap communicating with the back cover 8 and the reinforcement plate. Alternatively, the screw is fastened by providing the back cover 8 with a PEM nut.

However, according to the related art, the manufacturing costs of a product increase due to an increase in the number of components as auxiliary parts such as the reinforcement plate or the PEM nut are used.

### SUMMARY OF THE INVENTION

The present disclosure is directed to providing a tap processing method for an ACM panel, which is capable of forming, when a system board is attached to a back cover, a screw thread that may maintain sufficient screw fastening strength without using a separate auxiliary part by using the characteristics of the ACM panel.

A tap processing method for an ACM panel, which forms a screw thread in the ACM panel including a metallic inner skin, a metallic outer skin, and a resin core layer interposed between both skins, includes an inner burring operation of burring the inner skin of the ACM panel so that an inner burr formed in the inner skin extends toward the outer skin while compressing the core layer, an outer burring operation of burring the outer skin of the ACM panel so that the outer burr formed in the outer skin extends toward the inner skin while compressing the core layer and the inner burr and the outer burr are also continuously connected to each other, and a tapping operation of forming a continuous screw thread in the inner burr and the outer burr continuously connected to each other.

Burring work in the inner burring operation and the outer burring operation may be performed by a scrapless burring punch (SBP).

The tap processing method may further include a reference point setting operation of setting a burring reference point so that the inner burr formed in the inner burring operation and the outer burr formed in the outer burring operation are concentrically aligned before the outer burring operation.

The reference point setting operation may be performed such that, in the inner burring operation, the outer skin is punched by the punching part at a tip of the SBP and thus a punching hole serving as the burring reference point is formed.

In the outer burring operation, burring processing is performed by the SBP through the punching hole.

### BRIEF DESCRIPTION OF THE DRAWINGS

The above and other objects, features and advantages of the present disclosure will become more apparent to those of ordinary skill in the art by describing exemplary embodiments thereof in detail with reference to the accompanying drawings, in which:
FIG. 1 is a view illustrating a configuration in which a system board is attached to a back cover;
FIGS. 2A and 2B are views sequentially illustrating an inner burring operation according to the present disclosure;
FIGS. 3A and 3B are views sequentially illustrating an outer burring operation according to the present disclosure;
FIG. 4 is a view illustrating a tapping operation according to the present disclosure; and
FIG. 5 is a view illustrating a state in which a screw thread is formed in the ACM panel according to the present disclosure.

### DETAILED DESCRIPTION OF EXEMPLARY EMBODIMENTS

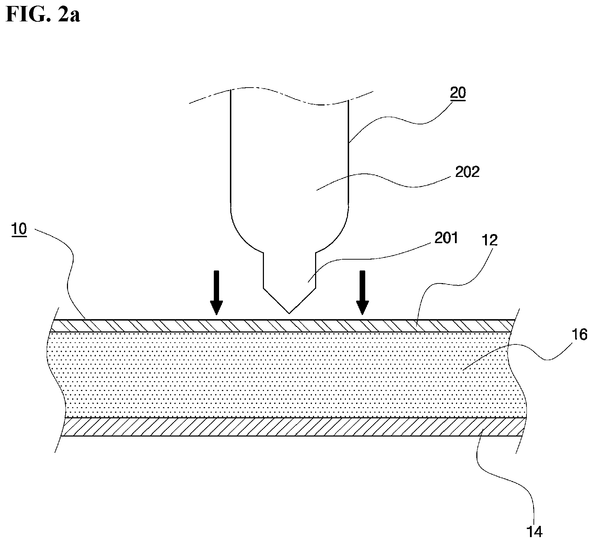

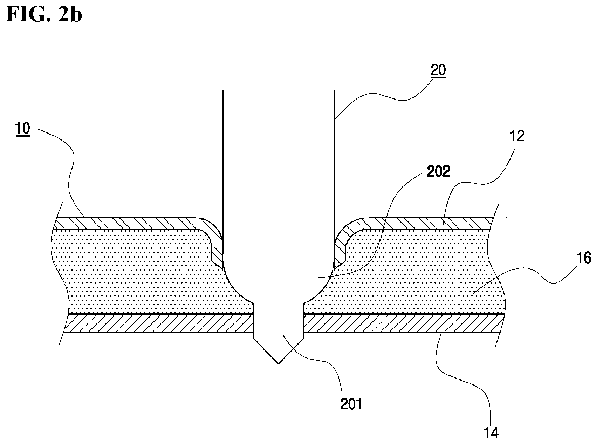

Hereinafter, specific details for implementing the present disclosure will be described in detail with reference to FIGS. 2 to 5.

A tap processing method for an ACM panel according to the present disclosure is intended to form a screw thread in an ACM panel 10 including an inner skin 12, an outer skin 14, and a core layer 16 interposed between both skins 12 and 14. The present disclosure may be applied when a hook is fastened instead of a screw.

Here, the inner skin 12 and the outer skin 14 of the ACM panel 10 applied to the present disclosure may be made of a metallic material (aluminum or the like) that may form burrs through a burring process, which will be described below. The core layer 16 may be made of a resin material that may form a relative repulsive stress while compressed as burrs 121 and 141 are formed in the inner skin 12 and the outer skin 14.

Further, the ACM panel 10 applied to the present disclosure is used as a back cover of a display device and thus may be limited to one having a thickness (0.25t or less) suitable for maintaining structural rigidity while a sufficient heat dissipation effect is possible.

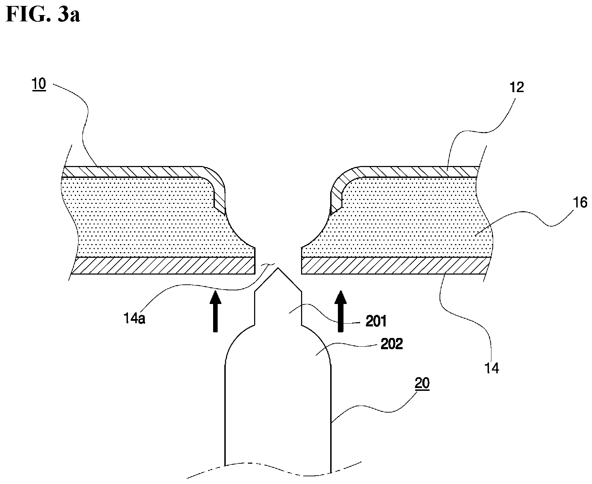

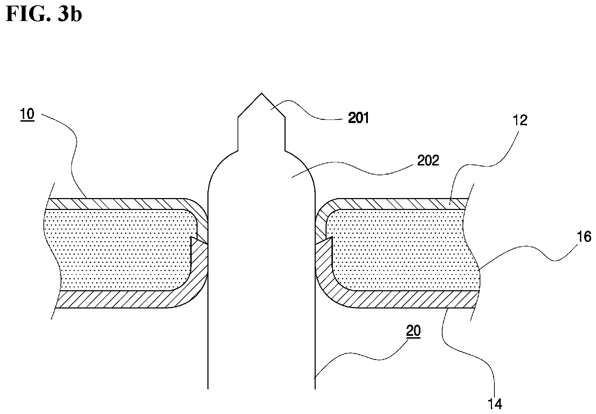

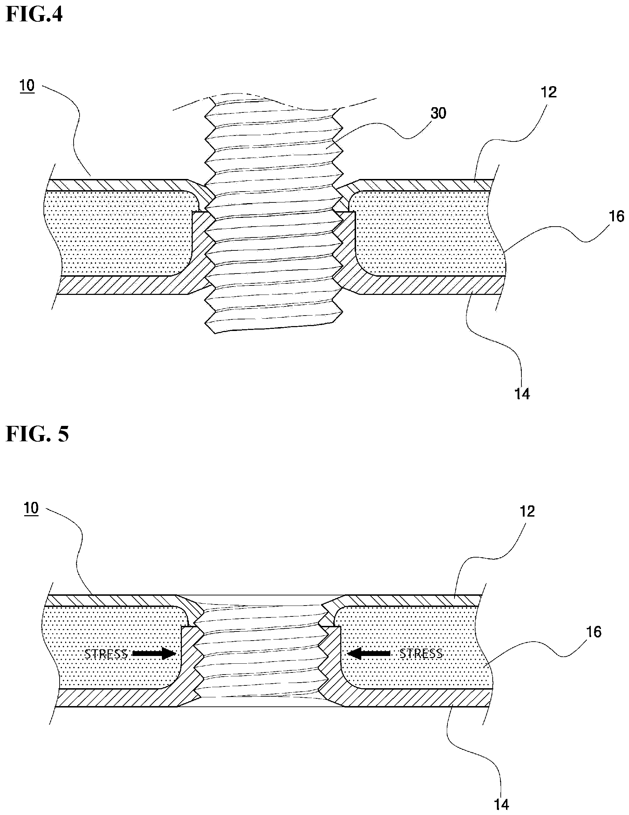

The tap processing method for the ACM panel according to the present disclosure includes the following operations.
1) An inner burring operation of burring the inner skin 12 of the ACM panel 10 so that the inner burr 121 formed in the inner skin 12 extends toward the outer skin 14 while compressing the core layer 16 (see FIGS. 2A and 2B).
2) an outer burring operation of burring the outer skin 14 of the ACM panel 10 so that the outer burr 141 formed in the outer skin 14 extends toward the inner skin 12 while compressing the core layer 16 and the inner burr 121 and the outer burr 141 are also continuously connected (see FIGS. 3A and 3B).
3) A tapping operation of forming a continuous screw thread in the inner burr 121 and the outer burr 141 that are continuously connected (see FIG. 4).

Here, burring work in the inner burring operation and the outer burring operation is performed by a scrapless burring punch (SBP) 20, and the SBP 20 includes a punching part 201 constituting a tip and a burring part 202 whose diameter gradually increases from that of the punching part 201.

The SBP 20 is mainly used for a thin object such as a panel or a pipe and serves to form a burr as the object is punched by the punching part 201 and a punched peripheral part is bent by the burring part 202 in an entry direction.

Further, in the tapping operation, inner surfaces of the inner burr 121 and the outer burr 141 are subjected to tapping using a tool such as a tap drill 30 to form screw thread.

Thus, according to the present disclosure, as illustrated in FIG. 5, by combination of the inner burr 121 formed in the inner burring operation and the outer burr 141 formed in the outer burring operation, the core layer 16 of the ACM panel 10 is compressed in a transverse direction, and thus the compressed core layer 16 applies relatively strong stress to the inner burr 121 and the outer burr 141.

Thus, the fastening strength of a screw fastened to the inner burr 121 and the outer burr 141 increases, and as a result, when the system board 5 is attached to the back cover 8, an attachment state of the system board 5 is firmly maintained without a separate auxiliary part.

Further, the present disclosure further includes a reference point setting operation of setting a burring reference point so that the inner burr 121 formed in the inner burring operation and the outer burr 141 formed in the outer burring operation may be concentrically aligned before the outer burring operation.

The reference point setting operation may be performed such that, in the inner burring operation, the outer skin 14 is punched by the punching part 201 at the tip of the SBP 20 and thus a punching hole 14a serving as the burring reference point is formed (see FIG. 3A).

Thus, when the outer burring is performed through the punching hole 14a formed in the outer skin 14, since the outer burr 141 and the inner burr 121 are concentrically aligned and are accurately continuously connected to each other, separate work for the concentric alignment of the inner burr 121 and the outer burr 141 is not required.

According to the present disclosure, when a system board is attached to a back cover of an ACM panel material using a screw, the stress of the ACM panel itself increases by burring processing without using a separate auxiliary part for increasing the fastening strength of the screw, and thus the fastening strength of the screw is stably maintained, which helps to improve the productivity of OLED display devices.

## Claims

1. A tap processing method for an aluminum composite material (ACM) panel, which forms a screw thread in the ACM panel including a metallic inner skin, a metallic outer skin, and a resin core layer interposed between both skins, the tap processing method comprising:
an inner burring operation of burring the inner skin of the ACM panel so that an inner burr formed in the inner skin extends toward the outer skin while compressing the core layer;
an outer burring operation of burring the outer skin of the ACM panel so that the outer burr formed in the outer skin extends toward the inner skin while compressing the core layer and the inner burr and the outer burr are also continuously connected to each other; and
a tapping operation of forming a continuous screw thread in the inner burr and the outer burr continuously connected to each other.

2. The tap processing method of claim 1, wherein burring work in the inner burring operation and the outer burring operation is performed by a scrapless burring punch (SBP) including a punching part at a tip thereof and a burring part whose diameter gradually increases from that of the punching part.

3. The tap processing method of claim 2, further comprising a reference point setting operation of setting a burring reference point so that the inner burr formed in the inner burring operation and the outer burr formed in the outer burring operation are concentrically aligned before the outer burring operation.

4. The tap processing method of claim 3, wherein the reference point setting operation is performed such that, in the inner burring operation, the outer skin is punched by the punching part at the tip of the SBP and thus a punching hole serving as the burring reference point is formed.

5. The tap processing method of claim 4, wherein, in the outer burring operation, burring processing is performed by the SBP through the punching hole.
